# EUROPÄISCHE PATENTANMELDUNG

(11) **EP 2 151 692 A2**
(43) Veröffentlichungstag der Anmeldung: **10.02.2010**
(21) Anmeldenummer: 09007173.9
(22) Anmeldetag: 29.05.2009
(51) Int. Cl.: G01R 15/20

(54) **Kompensationsstromwandler**

(30) Priorität: 06.08.2008 DE 102008036582
(71) Anmelder: REO Inductive Components AG, 42657 Solingen (DE)
(72) Erfinder: Resch, Otto, 84371 Triftern (DE)
(74) Vertreter: Haft, von Puttkamer, Berngruber, Karakatsanis

(57) **Zusammenfassung**

Die Erfindung betrifft einen Kompensationsstromwandler mit einem ferromagnetischen Kernelement (2), das einen Luftspalt (3) besitzt, in dem ein Sensorelement (4) angeordnet ist, wobei eine dem Kernelement (2) zugeordnete Kompensationswicklung (7) und eine Messeinrichtung (9) vorgesehen sind. Die Messeinrichtung (9) ermittelt ein Messsignal (MS), das eine Information über die Größe eines in einem Leiter (8) fließenden Primärstromes (I) anzeigt, wobei der Leiter (8) durch den vom Kernelement (2) umschlossenen Raum (11) verläuft. Ein weiteres, einen Luftspalt (6) aufweisendes ferromagnetisches Kernelement (5) ist in Bezug auf das Kernelement (2)so angeordnet, dass sein Luftspalt (6) dem Luftspalt (3) des Kernelementes (2) diametral gegenüber liegt. Die Kompensationswicklung (7) umgibt das Kernelement (2) und das weitere Kernelement (5) gemeinsam.

## Beschreibung

Die vorliegende Erfindung betrifft einen Kompensationsstromwandler nach dem Oberbegriff des Patentanspruches 1.

Ein derartiger Kompensationsstromwandler geht beispielsweise aus der DE 69 714 871 T2 hervor. Solche Kompensationsstromwandler dienen dazu, den in einem Leiter fließenden Strom zu messen. Der bekannte Kompensationsstromwandler umfasst im Wesentlichen einen ferromagnetischen Ring mit einem Luftspalt, wobei ein Leiter, in dem ein Primärstrom mit der zu messenen Stromstärke fließt, in den ferromagnetischen Ring einführbar ist. In dem Luftspalt des ferromagnetischen Ringes ist eine Hall-Sonde angeordnet, die über einen Verstärker eine Spannung liefert, die der magnetischen Induktion im Luftspalt entspricht. Es ist ferner eine Wicklung vorgesehen, die den ferromagnetischen Ring umgibt und in Serie zu einem Widerstand geschaltet ist. Eine elektrische Schaltung ist zwischen der Wicklung und dem Widerstand angeordnet und mit der Wicklung und der Hall-Sonde verbunden. Die elektrische Schaltung besitzt einen Verstärker und einen Rückkopplungskondensator zur Bildung einer geschlossenen Regelschleife, die den Klemmen des Widerstandes eine Spannung zuführt, die der Stromstärke des Primärstromes entspricht. In einem Summierglied werden die vom Verstärker gelieferte Spannung sowie die dem Widerstand zugeführte Spannung addiert, um eine Ausgangsspannung zu bilden, die proportional zur der zu messenden Stärke des Primärstromes ist.

Ein Problem eines derartigen Kompensationswandlers besteht darin, dass sich Messfehler ergeben können, die darauf zurückzuführen sind, dass der von einem Wechselstrom als Primärstrom durchflossene Leiter nicht stets in einer genau definierten Lage, z. B. zentrisch, in dem vom ferromagnetischen Ring umschlossenen Raum (Durchstecköffnung des Kompensationsstromwandlers für den Leiter) angeordnet ist. Dies ist insbesondere dann der Fall, wenn die Primärströme groß, beispielsweise größer als 1000 A, sind und wenn auch die Durchstecköffnung groß ist. Der von der Hall-Sonde gemessene Strom hat dann eine stärke Abhängigkeit von der jeweiligen Lage des Leiters in der Durchstecköffnung. Messabweichungen von etwa 10% sind hier durchaus zu verzeichnen.

Die Aufgabe der vorliegenden Erfindung besteht darin, einen Kompensationsstromwandler so auszugestalten, dass die gemessenen Werte eines von einem zu messenden Wechselstrom durchflossenen Leiters, der in einer vom ferromagnetischen Kern umschlossenen Raum angeordnet ist, unabhängig von der Lage bzw. Anordnung des Leiters in dem Raum sind.

Diese Aufgabe wird durch einen Kompensationsstromwandler mit den Merkmalen des Patentanspruches 1 gelöst.

Der wesentliche Vorteil des erfindungsgemäßen Kompensationsstromwandler besteht darin, dass er so ausgestaltet ist, dass stets exakte Messwerte erhalten werden, die den in einem Leiter fließenden Wechselstrom anzeigen, wobei die Messwerte unabhängig von der Position bzw. Anordnung des Leiters in dem vom ferromagnetischen Kern des Kompensationsstromwandlers umschlossenen Raum sind.

Ein weiterer wesentlicher Vorteil besteht darin, dass die von der Lage des Leiters in dem vom ferromagnetischen Kern des Kompensationsstromwandler umschlossenen Raum unabhängigen Messwerte mit einem Kompensationsstromwandler erhalten werden können, der mit einfachsten Mitteln realisierbar ist und zudem keine größeren Abmessungen aufweisen muss als ein vergleichbarer Kompensationswandler des Standes der Technik. Vorteilhafterweise wird der in dem Luftspalt des einen Kernelementes des Kernes angeordnete Hall-Sensor wegen der speziellen, versetzten Anordnung der beiden Kernelemente des Kernes von einer Seite her durch das andere Kernelement komplett magnetisch abgedeckt, sodass Störeinflüsse von dieser Seite her abgeschirmt werden und daher nicht zu verzeichnen sind.

Vorteilhafte Ausgestaltungen der Erfindung gehen aus den Unteransprüchen hervor.

Im Folgenden werden die Erfindung und deren Ausgestaltungen im Zusammenhang mit den Figuren näher erläutert. Es zeigen:
Figur 1 in schematischer Darstellung den Aufbau des Kernes erfindungsgemäßen Kompensationsstromwandlers aus zwei Kernelementen und
Figur 2 eine schematische Ansicht des erfindungsgemäßen Kompensationsstromwandlers in Verbindung mit einer Messeinrichtung zur Erläuterung des Messprinzips der vorliegenden Erfindung.

Im Zusammenhang mit der vorliegenden Erfindung hat es sich als völlig überraschend herausgestellt, dass diejenigen Messfehler in einer äußerst einfachen und wirkungsvollen Weise vermieden werden können, die auf sich verändernde Lagen bzw. Anordnungen des vom Primär-Wechselstrom durchflossenen Leiters in dem vom ferromagnetischen bzw. weichmagnetischen Kern des Kompensationsstromwandler umschlossenen Raum sind. Gemäß der vorliegenden Erfindung kann dies dadurch erfolgen, dass der Kern des Kompensationsstromwandlers in einer neuen und speziellen Weise so gestaltet wird, dass er zusätzlich zu einem einen Luftspalt aufweisenden ferromagnetischen Kernelement ein ebenfalls einen Luftspalt aufweisendes weiteres, dem einen Kernelement im wesentlichen identisches Kernelement deckungsgleich zu dem einen Kernelement aufweist. Dabei sind die beiden Kernelemente so angeordnet, dass sich ihre Luftspalte diametral gegenüberliegen. Eine vom Kunden nur sehr schwer zu realisierende Festlegung des Leiters in einer bestimmten Lage des vom ferromagnetischen Kern umschlossenen Raumes ist daher vorteilhafterweise nicht erforderlich. Üblicherweise ist bei Kompensationsstromwandlern die Stromübersetzung durch die eingebaute Kompensationsspule fest vorgegeben, sodass zur Fehlerkorrektur keine Nachregelung der Stromübersetzung erfolgen kann.

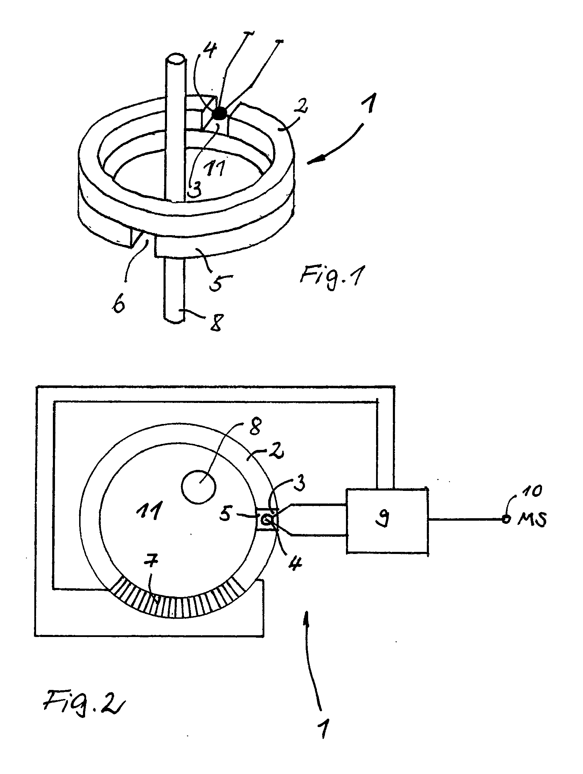

Gemäß Figur 1 umfasst der erfindungsgemäße Kompensationsstromwandler 1 im Wesentlichen einen Kern mit einem ersten ferromagnetischen, ringförmigen Kernelement 2, das in an sich bekannter Weise einen Luftspalt 3 besitzt, in dem ein Sensorelement, vorzugsweise ein Hall-Element 4, angeordnet ist. Der Kern des erfindungsgemäßen Kompensationsstromwandlers 1 umfasst ferner ein zweites ferromagnetisches, ringförmiges Kernelement 5, das vorzugsweise identisch mit dem ersten Kernelement 2 ausgebildet und deckungsgleich bzw. koaxial zu diesem angeordnet ist. Das zweite ferromagnetische Kernelement 5 besitzt ebenfalls einen Luftspalt 6, der dem Luftspalt 3 des ersten Kernelementes 2 diametral gegenüber angeordnet ist. Anders ausgedrückt bedeutet dies, dass die Kernelemente 2 und 5 deckungsgleich aufeinander liegen und um 180° gegeneinander verdreht sind. Die Kompensationswicklung 7 umgibt gemäß Figur 2 die beiden in dieser Weise aufeinander angeordneten Kernelemente 2 und 5. Es ist zweckmäßigerweise nur in einem Luftspalt 3 ein Hall-Element 4 angeordnet.

Beide Kernelemente 2 und 5 sind demselben, von dem im Leiter 8 fließenden Primärstrom erzeugten Magnetfeld ausgesetzt und werden durch dieses magnetisiert. Die gemeinsame Kompensationswicklung 7, kompensiert, von nur einem Kernelement gesteuert, beide Kernelemente 2 und 5.

Der durch den von den beiden Kernelementen 2 und 5 umschlossenen Raum 11 geführter Leiter 8, der von einem Wechselstrom durchflossen wird, ist in der Figur 1 schematisch dargestellt. Bei diesem Leiter 8 handelt es sich üblicherweise um einen so genannten Strombolzen.

In der aus der Figur 1 ersichtlichen Weise ist der Hall-Sensor 4 mit einer Messeinrichtung 9 verbunden, die an ihrem Ausgang 10 ein Messsignal MS erzeugt, das eine Abbildung des den Leiter 8 durchfließenden Wechsel-Primärstromes darstellt. Der durch den Leiter 8 fließende Primärstrom erzeugt ein Magnetfeld einer Amplitude und einer Richtung, das in dem die beiden Kernelemente 2 und 5 umfassenden Kern induziert wird. Die Messeinrichtung 9 erzeugt einen die Kompensationswicklung 7 durchfließenden Sekundärstrom, der ein Magnetfeld gleicher Amplitude in der entgegen gesetzten Richtung zu dem vom Primärstrom erzeugten Magnetfeld erzeugt. Der Sekundärstrom ist daher proportional zum Primärstrom. Der Hall-Sensor 4 gibt eine Spannung ab, die proportional zu dem Primärstrom im Leiter 8 ist.

Bevorzugt sind die beiden Kernelemente 2 und 5 um 180° gegeneinander versetzt. Es kann jedoch auch noch vorteilhaft sein, wenn die Verschiebung bzw. Verdrehung der beiden Luftspalte 3 und 6 gegeneinander in einem Winkelbereich von 120° bis 240°, vorzugsweise in einem Bereich von 150° bis 210°, liegt.

### Bezugszeichen:

- 1: Kompensationsstromwandler
- 2: Kernelement
- 3: Luftspalt
- 4: Sensorelement
- 5: Kernelement
- 6: Luftspalt
- 7: Kompensationswicklung
- 8: Leiter
- 9: Messeinrichtung
- 10: Ausgang
- MS: Messsignal

## Patentansprüche

1. Kompensationsstromwandler mit einem ferromagnetischen Kernelement (2), das einen Luftspalt (3) besitzt, in dem ein Sensorelement (4) angeordnet ist, wobei eine Kompensationswicklung (7) und eine Messeinrichtung (9) vorgesehen sind, wobei die Messeinrichtung (9) ein Messsignal (MS) erzeugt, das eine Information über die Größe eines in einem Leiter (8) fließenden Primärstromes (I) anzeigt, wobei der Leiter (8) durch den vom Kernelement (2) umschlossenen Raum (11) verläuft, **dadurch gekennzeichnet, dass** ein weiteres, einen Luftspalt (6) aufweisendes ferromagnetisches Kernelement (5) vorgesehen und in Bezug auf das Kernelement (2) so angeordnet ist, dass sein Luftspalt (6) dem Luftspalt (3) des Kernelementes (2) im wesentlichen gegenüber liegt, und dass die Kompensationswicklung (7) das Kernelement (2) und das weitere Kernelement (5) gemeinsam umgibt.

2. Kompensationsstromwandler nach Anspruch 1, **dadurch gekennzeichnet, dass** das Kernelement (2) und das weitere Kernelement (5) deckungsgleich aufeinander liegen.

3. Kompensationsstromwandler nach Anspruch oder 2, **dadurch gekennzeichnet, dass** das Kernelement (2) und das weitere Kernelement (5) identisch ausgebildet sind.

4. Kompensationsstromwandler nach einem der Ansprüche 1 bis 3, **dadurch gekennzeichnet, dass** der Luftspalt (3) des Kernelementes (2) und der Luftspalt (6) des weiteren Kernelementes (5) um 180° gegeneinander versetzt sind.

5. Kompensationsstromwandler nach einem der Ansprüche 1 bis 3, **dadurch gekennzeichnet, dass** der Luftspalt (3) des Kernelementes (2) und der Luftspalt (6) des weiteren Kernelementes (5) um einen Winkel gegeneinander versetzt sind, der in einem Bereich von 120° bis 240° liegt.

6. Kompensationsstromwandler nach einem der Ansprüche 1 bis 3, **dadurch gekennzeichnet, dass** der Luftspalt (3) des Kernelementes (2) und der Luftspalt (6) des weiteren Kernelementes (5) um einen Winkel gegeneinander versetzt sind, der in einem Bereich von 150° bis 210° liegt.

7. Kompensationsstromwandler nach einem der Ansprüche 1 bis 7, **dadurch gekennzeichnet, dass** das Sensorelement (4) ein Hall-Element ist.
